# EUROPEAN PATENT APPLICATION

(11) **EP 4 503 438 A1**
(43) Date of publication of application: **05.02.2025**
(21) Application number: 22935018.6
(22) Date of filing: 28.03.2022
(51) Int. Cl.: H03K 17/08, H03K 17/16, H02M 1/08

(54) **DRIVING CIRCUIT AND CONTROL METHOD FOR DRIVING CIRCUIT**

(71) Applicant: Hitachi Astemo, Ltd., Ibaraki 312-8503 (JP)
(72) Inventor: MIZUHASHI, Yoshiaki, Hitachinaka-shi, Ibaraki 312-8503 (JP); DOI, Masahiro, Hitachinaka-shi, Ibaraki 312-8503 (JP); IKUYAMA, Takeshi, Hitachinaka-shi, Ibaraki 312-8503 (JP); TAI, Shintaro, Hitachinaka-shi, Ibaraki 312-8503 (JP)
(74) Representative: Strehl Schübel-Hopf & Partner
(86) International application number: PCT/JP2022/014850
(87) International publication number: WO 2023/187863

(57) **Abstract**

Provided is a drive circuit capable of reducing the amount of surge during an off operation when an overcurrent is detected while reducing the switching loss during a normal operation. The present invention is characterized by including a switching element, an ON circuit that injects charge into a gate of the switching element according to a drive signal, a first OFF circuit that extracts charge from the gate of the switching element in response to a drive signal, and a second OFF circuit that is different from the first OFF circuit and extracts charge from the gate of the switching element in response to an overcurrent detection signal.

## Description

### Technical Field

The present invention relates to the configuration of a drive circuit and control for the drive circuit and particularly to a technique effective for application to the drive circuit of an inverter.

### Background Art

A voltage-driven power semiconductor such as an insulated gate bipolar transistor (IGBT) or SiC metal-oxide-semiconductor field-effect transistor (MOSFET) is used as a power semiconductor mounted on a power conversion device (inverter), and in recent years and has recently evolved toward higher withstand voltage and larger current.

The power conversion device is also used in an electrically powered vehicle and is also used in an application of converting DC power supplied from a battery into power to generate AC power for driving a motor. In such a field, it is required to reduce a switching loss in order to increase use the efficiency of a battery and suppress a loss due to heat generation in a power conversion device.

In addition, when an overcurrent occurs in a phase of the motor, control for protection is required in order to prevent the burnout of the motor and the like.

As a background art in the present technical field, for example, a technique such as disclosed in PTL 1 is available. PTL 1 discloses "A power conversion device capable of performing more effective protection control by providing priority between a plurality of protection circuits".

### Citation List

### Patent Literature

PTL 1: JP 2012-5229 A

### Summary of Invention

### Technical Problem

In order to reduce the switching loss of the power conversion device, it is necessary to lower a gate resistance RG of a switching element constituting the power conversion device and increase the slew rate representing the rate at which the output voltage can change per specified unit time.

On the other hand, in a case where the gate resistance RG is lowered and the slew rate is increased, the amount of surge also increases, and hence, there is a possibility that the surge voltage exceeds the device rated voltage and breaks the element.

Therefore, in the switching element of the conventional power conversion device, the gate resistance RG is generally determined under the worst conditions including a phase overcurrent. Since the drive capability is determined on the basis of the condition, the element size of the switching element is also limited.

According to the technique in PTL 1, when an overcurrent occurs in a phase of the motor, a process of turning off all switching elements of the three phases is performed by control similar to normal control. It is necessary to control the gate of a switching element so that the switching element is not destroyed even by the surge generated when the switching element is turned off in a large current state in an overcurrent condition. Accordingly, an optimized condition cannot be achieved for the driving of the switching element in the normal operation state.

Therefore, an object of the present invention is to provide a drive circuit and a control method for the drive circuit capable of reducing the amount of surge during an off operation when an overcurrent is detected while reducing the switching loss during a normal operation.

### Solution to Problem

In order to solve the above problem, the present invention is characterized by including a switching element, an ON circuit that injects charge into a gate of the switching element according to a drive signal, a first OFF circuit that extracts charge from the gate of the switching element in response to a drive signal, and a second OFF circuit that is different from the first OFF circuit and extracts charge from the gate of the switching element in response to an overcurrent detection signal.

The present invention is characterized by including injecting charge into a gate of a switching element in response to an ON signal, extracting charge from the gate of the switching element in response to an OFF signal, and upon detecting an overcurrent, extracting charge from the gate of the switching element through a path different from a path from which charge is extracted according to the OFF signal.

### Advantageous Effects of Invention

According to the present invention, it is possible to implement a drive circuit and a control method for the drive circuit capable of reducing the amount of surge during an off operation when an overcurrent is detected while reducing the switching loss during a normal operation.

This makes it possible to improve the efficiency and reliability of the power conversion device (inverter).

Problems, configurations, and effects other than those described above will be clarified by the following description of embodiments.

### Brief Description of Drawings

[FIG. 1] FIG. 1 is a diagram illustrating a schematic configuration of a power conversion device according to a first embodiment of the present invention.
[FIG. 2] FIG. 2 is a diagram illustrating the circuit configuration of a pre-driver 400 in FIG. 1.
[FIG. 3] FIG. 3 is a graph illustrating the relationship between slew rate and surge in a switching element.
[FIG. 4] FIG. 4 is a graph illustrating a loss in a switching element.
[FIG. 5] FIG. 5 is a diagram illustrating a schematic configuration of a power conversion device according to a second embodiment of the present invention.
[FIG. 6] FIG. 6 is a diagram illustrating the circuit configuration of a pre-driver 420 in FIG. 5.

### Description of Embodiments

Hereinafter, embodiments of the present invention will be described with reference to the drawings. In the drawings, the same components are denoted by the same reference numerals, and a detailed description of overlapping components will be omitted.

### First embodiment

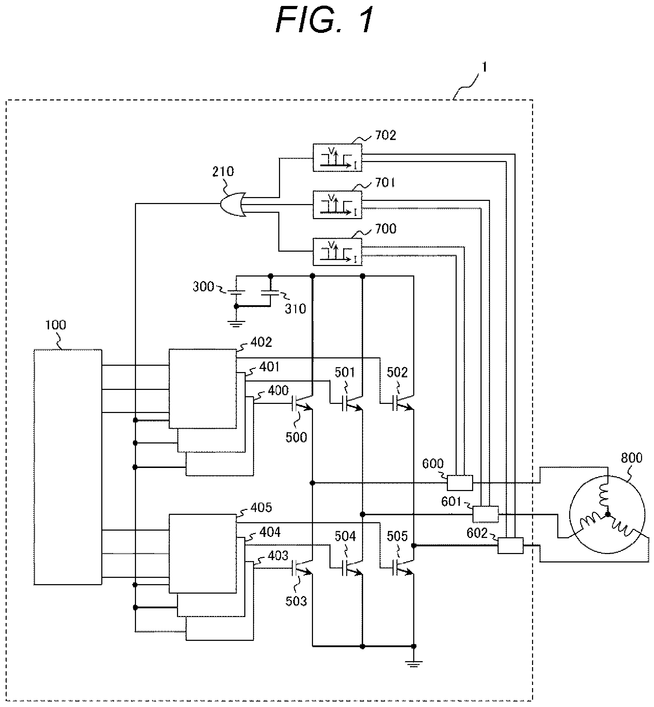

A drive circuit and a control method for the drive circuit according to the first embodiment of the present invention will be described with reference to FIGS. 1 to 4.

FIG. 1 is a diagram illustrating a schematic configuration of a power conversion device (inverter) 1 according to the present embodiment and an example in which the power conversion device 1 is connected between a battery 300 and an electric motor 800.

As illustrated in FIG. 1, the power conversion device 1 of the present embodiment includes, as main components, switching elements 500 to 505, a control circuit 100, pre-drivers 400 to 405, current sensors 600 to 602, and overcurrent detection circuits 700 to 702.

For the switching elements 500 to 505, a voltage-driven power semiconductor such as an IGBT or a SiC MOSFET is used. However, the present invention is not limited to the IGBT or the SiC MOSFET, and other power semiconductors may be used. By charging and discharging charge to and from each control terminal of the switching elements 500 to 505, switching of the switching elements 500 to 505 is performed to switch the path through which a current flows, whereby power is converted from the battery 300 side to the electric motor 800 side.

The control circuit 100 outputs control signals to the pre-drivers 400 to 405 based on operation instruction information (for example, a target rotation speed, a target torque, and the like) for the electric motor 800 from a higher-level control unit not illustrated.

The battery 300 supplies a DC voltage serving as a power source in the power conversion device 1.

A capacitor 310 plays a role of supplying power and stabilizing the voltage in an instantaneous voltage drop when the electric motor 800 is driven. In addition, noise generated in a switching operation of the switching elements 500 to 505 to be described later is reduced by charging and discharging charge to and from the capacitor 310.

The pre-drivers 400 to 405 are pre-driver circuits that respectively drive the switching elements 500 to 505.

The current sensors 600 to 602 detect information on the amount of current flowing through each phase of the power supply system to the electric motor 800 and output the information to the overcurrent detection circuits 700 to 702. The current sensors 600 to 602 each may use a method of detecting by a magnetic field using a Hall element, a method of detecting by using a shunt resistor, or other methods.

The overcurrent detection circuits 700 to 702 each are a circuit that detects an overcurrent in a corresponding phase of the power supply system to the electric motor 800. When the current in each phase detected by a corresponding one of the current sensors 600 to 602 exceeds a predetermined positive/negative value, an output indicating that the current is an overcurrent is output.

For example, in a case where the current sensors 600 to 602 use Hall elements, if it is determined by using two comparators that the current in each phase of the electric motor 800 is equal to or more than a predetermined positive value or equal to or less than a predetermined negative value, a detection result indicating that the current is an overcurrent is output.

An OR circuit 210 is a circuit that calculates the OR of the overcurrent detection circuits 700 to 702 and outputs the result to the pre-drivers 400 to 405. As a result, when an overcurrent is detected in any one system of the respective phases of the electric motor 800, a shut-off process due to the overcurrent is performed by one of the pre-drivers 400 to 405.

The OR circuit 210 may have a latch function. Upon detecting an overcurrent state, the OR circuit 210 may hold the overcurrent state until the state is released. The held state may be released by an instruction from the control circuit 100 or may be released after the overcurrent state is held for a certain period of time.

The electric motor 800 receives electric power and operates as a motor. The present embodiment assumes that a three-phase motor is used as the electric motor 800 and exemplifies a case where the electric motor 800 is driven by using the six switching elements 500 to 505 mounted on the power conversion device 1. However, the present invention is not limited to this, and the number of phases of the electric motor 800 and the number of switching elements may be increased or decreased, including circuits for driving according to the configuration.

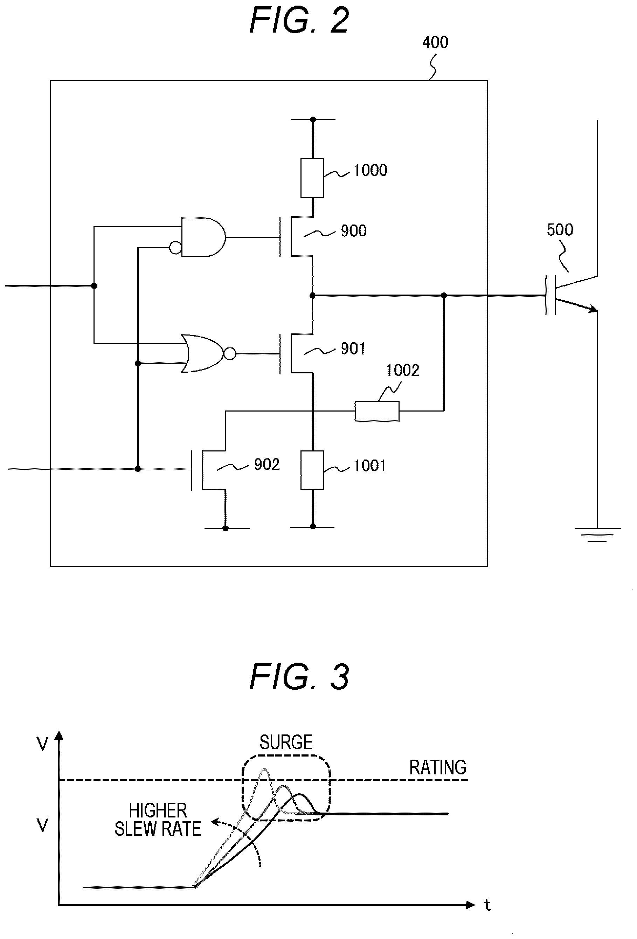

The detailed operation of the pre-drivers 400 to 405 will be mainly described with reference to FIG. 2. FIG. 2 is a diagram illustrating a circuit configuration of the pre-driver 400 in FIG. 1 and a circuit (pre-driver 400) corresponding to one system of the pre-drivers 400 to 405 that drive the switching elements 500 to 505.

As illustrated in FIG. 2, the pre-driver 400 includes a drive circuit 900 that injects charge into the control terminal of the switching element 500 via a resistor 1000, a drive circuit 901 that extracts charge from the control terminal of the switching element 500 via a resistor 1001, and a drive circuit 902 that extracts charge from the control terminal of the switching element 500 via a resistor 1002.

During a normal operation, the switching element 500 is controlled using the drive circuit 900 and the drive circuit 901. In a case where the signal input from the control circuit 100 issues an ON instruction, the drive circuit 900 injects charge into the control terminal of the switching element 500 to turn on the switching element 500.

In a case where the signal input from the control circuit 100 issues an OFF instruction, the drive circuit 901 extracts charge from the control terminal of the switching element 500 to turn off the switching element 500.

On the other hand, when an overcurrent is detected in a phase of the electric motor 800 to be described later, a process of extracting charge from the control terminal of the switching element 500 is performed using the drive circuit 902. That is, the drive circuit 902 extracts charge from the control terminal of the switching element 500 to turn off the switching element 500. At this time, both the drive circuit 900 and the drive circuit 901 are in an OFF state, and charge is extracted using only the drive circuit 902. In other words, when an overcurrent in a phase is detected, the drive circuit 900 and the drive circuit 901 are invalidated.

In the process at the time of overcurrent detection, the resistance value of the resistor 1002 is larger than the resistance value of the resistor 1001, and the speed of charge extraction is lower than that in the process at the time of normal operation.

FIG. 3 is a diagram illustrating the relationship between slew rate and surge in a switching element.

As illustrated in FIG. 3, the higher the speed of charge extraction from the control terminal and the higher the slew rate of the switching element, the larger the surge generated in the switching element 500, and the higher the possibility that the surge voltage exceeds the rated voltage and destroys the switching element 500. In particular, at the time of overcurrent detection, a large current flows as compared with that at the time of normal operation, and there is a high possibility that a larger surge occurs.

Therefore, in the pre-driver 400 according to the present embodiment, the switching element 500 is controlled to be turned off using the drive circuit 901 and the resistor 1001 during a normal operation, and the switching element 500 is controlled to be turned off using the resistor 1002 and the drive circuit 902 having a larger resistance value than the resistor 1001 during overcurrent detection.

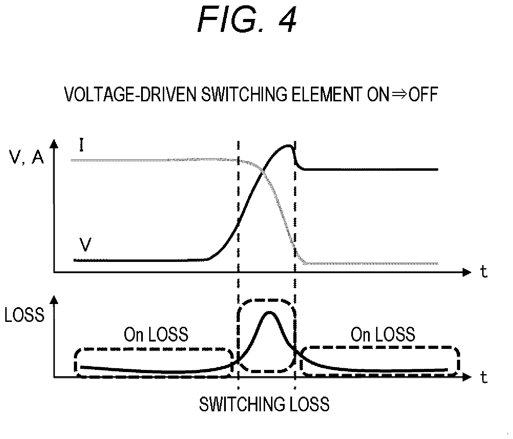

FIG. 4 is a graph illustrating a loss in a switching element. As illustrated in FIG. 4, loss in the voltage-driven switching element used in the power conversion device is classified into On loss occurring when the switching element is turned on and switching loss occurring when the switching element is switched from on to off. Since On loss is determined by the characteristics of the switching element, the loss cannot be reduced unless the characteristics of the switching element are improved.

On the other hand, it is possible to shorten the time required for switching by increasing the amount of charge injected or extracted to or from the control terminal of the switching element and increasing the slew rate of switching of the switching element. This can reduce the switching loss.

In the conventional pre-driver configuration, when an overcurrent is detected in a phase of the electric motor 800 during a normal operation, the same control is performed using the same drive circuit and the same resistor, that is, using the drive circuit 901 and the resistor 1001 in FIG. 2.

Therefore, it is necessary to limit the speed of charge extraction from the control terminal and suppress the slew rate of the switching element 500 by selecting a large value as the resistance value of the resistor corresponding to the resistor 1001 so that the switching element 500 is not destroyed by surge even with a large current when the overcurrent is detected.

Therefore, even during the normal operation, the resistance value of the resistor corresponding to the resistor 1001 becomes large, and the switching loss cannot be reduced.

In the pre-driver 400 according to the present embodiment, the drive circuit used for extracting charge from the control terminal is separated between a normal operation and a case where an overcurrent is detected in a phase of the electric motor 800. This makes it possible to individually adjust the resistor 1001 used during a normal operation and the resistor 1002 used when an overcurrent is detected in a phase of the electric motor 800.

As a result, during a normal operation, by increasing the speed of charge extraction from the control terminal and increasing the slew rate of the switching element 500, the switching loss can be reduced and the loss can be suppressed, which leads to improvement of the utilization efficiency of the battery 300.

In addition, when an overcurrent is detected in the phase of the electric motor 800, the surge amount at a large current can be adjusted by the resistor 1002, and breakdown of the switching element 500 can be prevented.

Note that, in this case, although the configuration has been described using the pre-driver 400, the pre-driver 401 to 405 each also have a similar configuration.

As described above, the power conversion device 1 according to the present embodiment includes the switching elements 500 to 505, the ON circuit (the drive circuit 900 and the resistor 1000) that injects charge into the gates of the switching elements 500 to 505 according to a drive signal from the control circuit 100, the first OFF circuit (the drive circuit 901 and the resistor 1001) that extracts charge from the gates of the switching elements 500 to 505 according to a drive signal from the control circuit 100, and the second OFF circuit (the drive circuit 902 and the resistor 1002) that extracts charge from the gates of the switching elements 500 to 505 according to an overcurrent detection signal and is different from the first OFF circuit (the drive circuit 901 and the resistor 1001).

The speed of charge extraction from the gate of the switching elements 500 to 505 by the second OFF circuit (the drive circuit 902 and the resistor 1002) is lower than the speed of charge extraction from the gate of the switching elements 500 to 505 by the first OFF circuit (the drive circuit 901 and the resistor 1001).

According to the present embodiment, it is possible to provide an efficient power conversion device that reduces the speed of charge extraction from the control terminals of the switching elements 500 to 505 to suppress the amount of surge generated in the switching elements 500 to 505 when an overcurrent is detected in a phase of the electric motor 800 and, at the time of normal operation, increases the slew rate of the switching elements 500 to 505 to reduce a switching loss and increase the use efficiency of the battery 300.

### Second embodiment

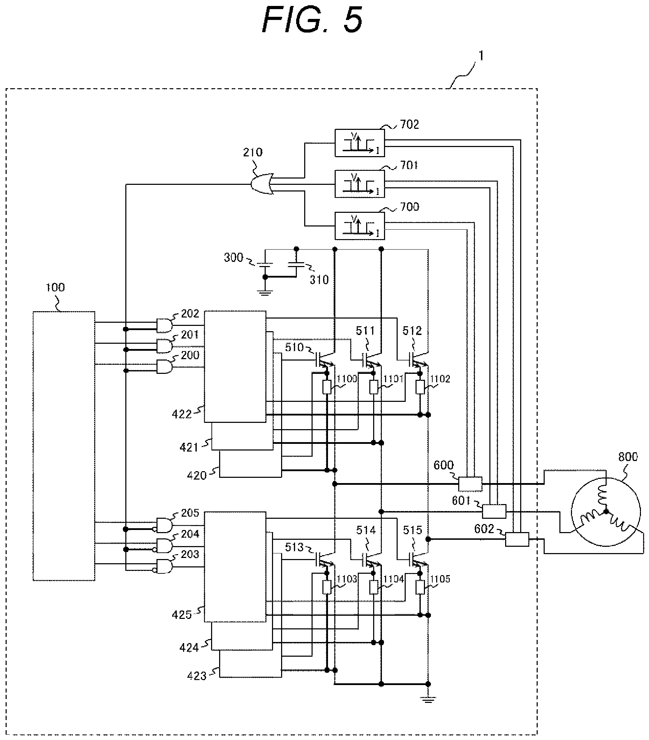

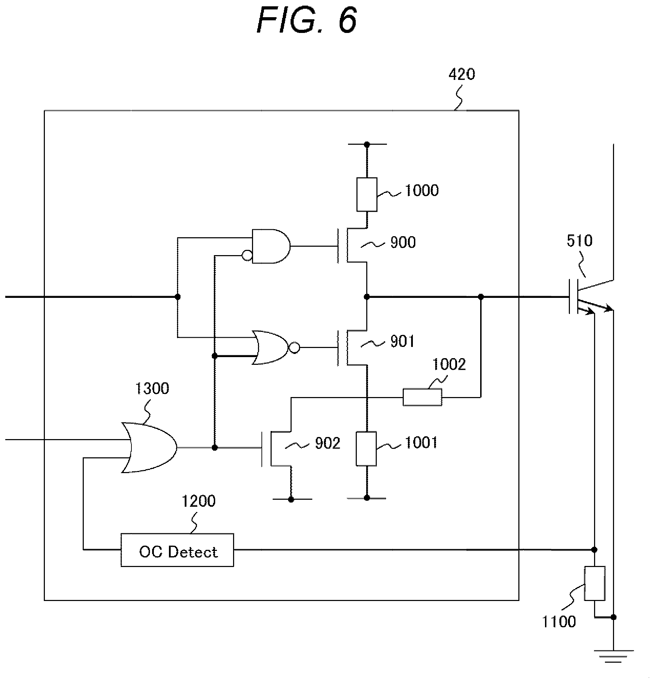

A drive circuit and a control method for the drive circuit according to the second embodiment of the present invention will be described with reference to FIGS. 5 and 6.

FIG. 5 is a diagram illustrating a schematic configuration of a power conversion device (inverter) 1 according to the present embodiment and an example in which the power conversion device 1 is connected between a battery 300 and an electric motor 800.

As illustrated in FIG. 6, the power conversion device 1 according to the present embodiment differs from that of the first embodiment (FIG. 2) in that an overcurrent detection circuit 1200 for detecting an overcurrent in each of switching elements 510 to 515 is disposed in each of pre-drivers 420 to 425.

The detailed operation of the pre-drivers 420 to 425 will be mainly described with reference to FIG. 6. FIG. 6 is a diagram illustrating the circuit configuration of the pre-driver 420 in FIG. 5 and a circuit (the pre-driver 420) corresponding to one system of the pre-drivers 420 to 425 that drive the switching elements 510 to 515.

As illustrated in FIG. 6, the pre-driver 420 charges and discharges charge to and from the control terminal of the switching element 510 during a normal operation by drive circuits 900 and 901 via a resistor 1000 and a resistor 1001.

On the other hand, when overcurrent detection circuits 700 to 702 detect an overcurrent in a phase of the electric motor 800, a drive circuit 902 controls the charge extraction amount using a resistor 1002 via an OR circuit 1300 to extract charge from the control terminal of the switching element 510 and perform the shut-off process of the switching element 510.

In addition, if the overcurrent detection circuit 1200 detects a voltage equal to or higher than a predetermined value, an overcurrent is detected in the switching element 510, and the drive circuit 902 extracts charge from the control terminal of the switching element 510 via the OR circuit 1300 to perform a shut-off process.

Both an overcurrent in a phase of the electric motor 800 and an overcurrent in the switching element 510 indicate a state where a shut-off process from a large current state needs to be performed. That is, this indicates an environment in which the surge tends to be large for the switching element.

In these two states, the drive circuit 902 slowly extracts the charge stored in the control terminal of the switching element 510 via a resistor 1002 having a resistance value larger than that of the resistor 1001, so that the surge amount is suppressed to be low. At the time of normal operation, the drive circuit 901 different from the drive circuit 902 is used to perform charge extraction via the resistor 1001 having a low resistance value, so that the slew rate of the switching element 510 is increased to reduce the switching loss, and the utilization efficiency of the battery 300 can be improved.

In addition, by sharing a circuit corresponding to an overcurrent in a phase of the electric motor 800 and an overcurrent in the switching element 510, the circuit scale can be minimized.

Note that, in this case, although the configuration has been described using the pre-driver 420, the pre-driver 421 to 425 each also have a similar configuration.

The switching elements 510 to 515 are voltage-driven switching elements similarly to the switching elements 500 to 505 according to the first embodiment, and a voltage-driven power semiconductor such as an IGBT or a SiC MOSFET is used. However, the present invention is not limited to the IGBT or the SiC MOSFET, and other power semiconductors may be used. Similarly to the first embodiment, switching is performed by charging and discharging charges to and from the control terminal, and power conversion is performed by switching the path through which a current flows.

However, unlike the first embodiment, the switching elements 510 to 515 according to the present embodiment each have an auxiliary terminal for obtaining the amount of flowing current to detect an overcurrent.

This auxiliary terminal is configured such that a current having a constant ratio with respect to a current flowing through the main path flows and is configured by, for example, a current mirror circuit. In the case of the current mirror circuit, the ratio is determined by the area ratio to the control terminal connected together.

Resistors 1100 to 1105 are respectively connected to the auxiliary terminals. Upon current-voltage conversion, the converted voltages are respectively input to the pre-drivers 420 to 425. If the voltage input to each of the pre-drivers 420 to 425 exceeds the voltage corresponding to the overcurrent in the switching element obtained from the current-voltage conversion and the current ratio of the auxiliary terminal, the overcurrent detection circuit 1200 in each of the pre-drivers 420 to 425 determines that the overcurrent flows through a corresponding one of the switching elements 510 to 515 and performs a shut-off process.

As described above, the power conversion device 1 according to the present embodiment includes the first overcurrent detection circuit (the overcurrent detection circuits 700 to 702) that detects an overcurrent in a phase and the second overcurrent detection circuit (the overcurrent detection circuit 1200) that detects an overcurrent in the switching elements 510 to 515 and shares the OFF circuit including the drive circuit 902 and the resistor 1002 between the OFF circuit that extracts charge from the gate of each of the switching elements 510 to 515 when the first overcurrent detection circuit (the overcurrent detection circuits 700 to 702) detects an overcurrent in a phase and the OFF circuit that extracts charge from the gate of each of the switching elements 510 to 51 when the second overcurrent detection circuit (the overcurrent detection circuit 1200) detects an overcurrent in the switching element.

In each of the above embodiments, the drive circuit has been described as an example of a power conversion device that drives an electric motor. However, the present invention is not limited to this and can be applied to an in-vehicle inverter circuit, an uninterruptible power supply device, a power conversion device for a train or a ship, an industrial power conversion device such as an electric motor of a factory facility, a power conversion device of a solar power generation system, a power conversion device of a home electric motor, and the like.

In addition, the present invention is not limited to the above-described embodiments and includes various modifications. For example, the above-described embodiments have been described in detail for easy understanding of the present invention and are not necessarily limited to those having all the described configurations. In addition, a part of the configuration of a certain embodiment can be replaced with a configuration of another embodiment, and the configuration of another embodiment can be added to the configuration of a certain embodiment. In addition, it is possible to add, delete, and replace other configurations with respect to a part of the configuration of each embodiment.

### Reference Signs List

1 power conversion device (inverter)
100 control circuit
210 OR circuit
300 battery
310 capacitor
400 to 405, 420 to 425 Pre-driver
500 to 505, 510 to 515 switching element
600 to 602 current sensor
700 to 702, 1200 overcurrent detection circuit
800 electric motor
900 to 902 drive circuit
1000 to 1002, 1100 to 1105 resistor
1300 OR circuit

## Claims

1. A drive circuit comprising:
a switching element;
an ON circuit that injects charge into a gate of the switching element according to a drive signal;
a first OFF circuit that extracts charge from the gate of the switching element in response to a drive signal; and
a second OFF circuit that is different from the first OFF circuit and extracts charge from the gate of the switching element in response to an overcurrent detection signal.

2. The drive circuit according to claim 1, wherein when charge is extracted from the gate of the switching element using the second OFF circuit, the ON circuit and the first OFF circuit are set in an OFF state.

3. The drive circuit according to claim 1, wherein a speed of charge extraction from the gate of the switching element by the second OFF circuit is lower than a speed of charge extraction from the gate of the switching element by the first OFF circuit.

4. The drive circuit according to claim 3, wherein
the first OFF circuit includes a first resistor,
the second OFF circuit includes a second resistor,
the first resistor controls the speed of charge extraction from the gate of the switching element by the first OFF circuit, and
the second resistor controls the speed of charge extraction from the gate of the switching element by the second OFF circuit.

5. The drive circuit according to claim 4, wherein the second resistor has a resistance value larger than a resistance value of the first resistor.

6. The drive circuit according to claim 1, wherein the ON circuit and the first OFF circuit are invalidated when an overcurrent is detected in a phase.

7. The drive circuit according to claim 1, wherein an overcurrent is detected in a phase, an OR of the overcurrent in the phase is held.

8. The drive circuit according to claim 7, wherein a control circuit that outputs the drive signal clears a held state of the OR.

9. The drive circuit according to claim 7, wherein the held state of the OR is cleared after a lapse of a predetermined period of time.

10. The drive circuit according to claim 1, further comprising:
a first overcurrent detection circuit that detects an overcurrent in a phase; and
a second overcurrent detection circuit that detects an overcurrent in the switching elements,
wherein the second OFF circuit is shared between an OFF circuit that extracts charge from the gate of the switching element when the first overcurrent detection circuit detects an overcurrent in a phase and an OFF circuit that extracts charge from the gate of the switching element when the second overcurrent detection circuit detects an overcurrent in the switching element.

11. A control method for a drive circuit, the method comprising:
injecting charge into a gate of a switching element in response to an ON signal;
extracting charge from the gate of the switching element in response to an OFF signal; and
upon detecting an overcurrent, extracting charge from the gate of the switching element through a path different from a path from which charge is extracted according to the OFF signal.

12. The control method for the drive circuit according to claim 11, wherein a speed of charge extraction when the overcurrent is detected is lower than a speed of charge extraction according to the OFF signal.

13. The control method for the drive circuit according to claim 11, wherein when an overcurrent is detected in a phase, an OR of the overcurrent in the phase is held.

14. The control method for the drive circuit according to claim 13, wherein a held state of the OR is cleared after a lapse of a predetermined period of time.

15. The control method for the drive circuit according to claim 11, wherein a same path from which charge is extracted is shared between a path from which charge is extracted used when an overcurrent is detected in a phase and a path from which charge is extracted used when an overcurrent is detected in the switching element.
